# EUROPEAN PATENT APPLICATION

(11) **EP 1 837 963 A2**
(43) Date of publication of application: **26.09.2007**
(21) Application number: 06023250.1
(22) Date of filing: 08.11.2006
(51) Int. Cl.: H01S 5/022

(54) **Laser package adaptor**

(30) Priority: 05.01.2006 US 325396
(71) Applicant: Emcore Corporation, Somerset, NJ 08873 (US)
(72) Inventor: Miao, Rongsheng, El Monte, CA 91732 (US); Kha, Nghia (Leo), Diamond Bar, CA 91765 (US); Olson, Todd, San Marino, CA 91108 (US)
(74) Representative: Geyer, Ulrich F.

(57) **Abstract**

The present invention discloses an adaptor suitable for use in optoelectronic circuit board. The adaptor according the present invention serves to adapt a package pin-out arrangement to a desired pin-out arrangement on a printed circuit board. The adaptor comprises a pin-in arrangement that electrically couples with the package pin-out arrangement. The adaptor further comprises an adaptor pin-out arrangement that is geometrically identical to the desired pin-out, and a flex-circuit that provides a plurality of electrical paths to connect the pin-in arrangement with the adaptor pin-out arrangement. In various embodiments, the adaptor further comprises a clamshell for holding the adaptor pin-out and the flex-circuit together in a single flat format.

## Description

### FIELD OF INVENTION

The present invention relates to semiconductor laser packages used in mounting lasers on optoelectronic circuit boards. More specifically, the present invention relates to adaptors suitable for use in optoelectronic circuit boards for adapting the pin-out of a first laser package to a desired pin-out on a printed circuit board.

### BACKGROUND OF THE INVENTION

Semiconductor laser devices are used for many purposes in various applications today. These devices such as edge-emitting lasers and vertical cavity surface emitting lasers (VCSELs) find application in the optoelectronics and the telecommunications industry. Deployment of lasers in optoelectronic circuit boards is often done using a hermetically sealed housing or a package to house the laser and possibly various other optical or electronic devices. This semiconductor laser package protects the electronic and optical devices from degradation by deleterious ambient contaminants, such as moisture and dust in the atmosphere. Further, the semiconductor laser package serves as a heat dissipater to cool the sealed components in it.

Many semiconductor laser package designs for VCSELs and edge-emitting lasers are known in the art. Two such semiconductor laser package designs used for optoelectronic circuit boards are the coaxial laser package (or "Transistor outline" TO can) and the rectangular, flat "butterfly" laser package.

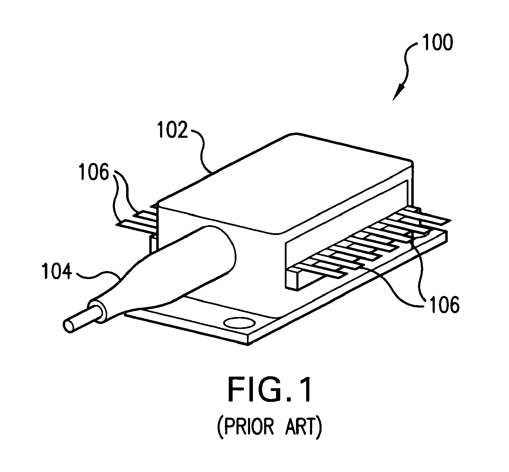

The butterfly laser package design is widely accepted in the optoelectronic industry. FIG. 1 is an illustration of a butterfly laser package 100 comprising a flat package subassembly 102 and a fiber module 104. Butterfly laser package 100 further comprises a butterfly pin-out 106, with two rows of pins extending on opposite sides of flat package subassembly 102. The two rows of pins in butterfly pin-out 106 are on the same plane, making it convenient to integrate the package with the optoelectronic circuit boards (not shown in figure). Therefore, the butterfly package design is widely used in the optoelectronics industry.

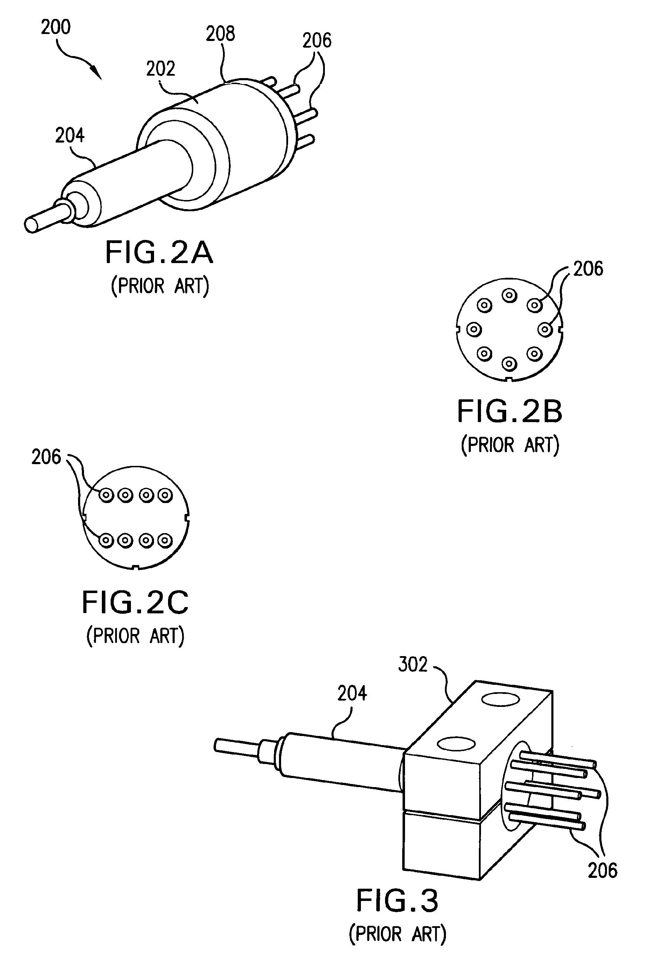

Further, the coaxial laser package design has shown great adoption potential due to its ease of manufacturing and low cost. FIGS. 2A, 2B, 2C illustrate a coaxial laser package 200. FIG. 2A illustrates an isometric view of coaxial laser package 200 comprising a TO header subassembly 202 and a fiber module 204. Coaxial laser package 200 further comprises a coaxial pin-out 206, with pins extending perpendicularly from the header surface of TO header subassembly 202. Various forms of pin orientations for coaxial pin-out 206 are known in the art. For example, the pins of coaxial pin-out 206 can be oriented in a circular form as shown in FIG. 2B, or in rows as shown in FIG. 2C..

Fiber module 204 is used to couple the laser lights coming out of TO header subassembly 202 for its subsequent usage in optoelectronic device. A laser diode, other optical devices and IC components (not shown in figure) are mounted inside TO header subassembly 202 and hermetically sealed with a TO-can 208.

Fig. 3 is an illustration of a coaxial laser package 200 with a metal clamp 302 for mounting TO-can 208 of coaxial laser package 200 on to a heat sink (not shown in figure) for cooling purposes.

It is desirable to use a coaxial laser package in optoelectronic circuit boards due to their ease of manufacturing and low cost. However, existing optoelectronic circuit board designs are adapted to use a butterfly laser package. The differences between butterfly pin-out 106 and coaxial pin-out 206 make it impossible to directly replace a butterfly laser package with a coaxial laser package on existing optoelectronic circuit board designs. Thus, there is a need for an invention to facilitate the use of a coaxial laser package in place of a butterfly laser package.

### SUMMARY OF THE INVENTION

The present invention discloses an adaptor suitable for use in an optoelectronic circuit board, for adapting a package pin-out arrangement to a desired pin-out arrangement on a printed circuit board.

In an embodiment, the present invention discloses an adaptor suitable for use in an optoelectronic circuit boards for adapting a package pin-out arrangement to a desired pin-out arrangement on a printed circuit board. The adaptor comprises a pin-in arrangement designed to electrically couple with the package pin-out arrangement, an adaptor pin-out arrangement that is geometrically identical to the desired pin-out, and a flex-circuit that provides a plurality of electrical paths to connect the pin-in arrangement with the adaptor pin-out arrangement.

In another embodiment, the present invention discloses an adaptor suitable for use in an optoelectronic circuit boards for adapting a package pin-out arrangement to a desired package pin-out arrangement on a printed circuit board. The adaptor comprises a flex-circuit. The flex-circuit further comprises a pin-in arrangement designed to electrically couple with the package pin-out arrangement, a pin-out that is geometrically identical to the desired pin-out, and one-to-one electrical connections between the pin-out of the package pin-out arrangement and the adaptor pin-out arrangement.

Various embodiments of the present invention are suitable for adapting the pin-out of a coaxial laser package to the pin-out of a butterfly laser package.

### BRIEF DESCRIPTION OF THE DRAWINGS

The present invention will hereinafter be described in conjunction with the appended drawings provided to illustrate the invention, wherein like designations denote like elements, and in which:

FIG. 1A shows an isometric view of a butterfly laser package as known in the art.

FIG. 2A shows an isometric view of the coaxial laser package as known in the art.

FIG. 2B shows a view of one known orientation of pins in a coaxial pin-out.

FIG. 2C shows view of another known orientation of pins in a coaxial pin-out.

FIG. 3 shows a metal clamp used on coaxial laser package to connect the package to a heat sink in accordance with prior art.

FIG. 4 shows an isometric view of a flex-circuit used in an adaptor in accordance with an embodiment of the present invention.

FIG. 5 shows an isometric view of a coaxial laser package mating with the flex-circuit in accordance with an exemplary embodiment of the present invention.

FIG. 6 shows an isometric view of a clamshell for use in conjunction with the flex-circuit, in accordance with an embodiment of the present invention.

FIG. 7 shows an isometric view of the adaptor, in accordance with an embodiment of the present invention, coupled with a coaxial laser package.

### DETAILED DESCRIPTION OF THE INVENTION

In the foregoing specification, specific embodiments of the present invention have been described. However, one of ordinary skill in the art will appreciate that various modifications and changes can be made without departing from the scope of the present invention as set forth in the claims below. Accordingly, the specification and figures are to be regarded in an illustrative rather than a restrictive sense, and all such modifications are intended to be included within the scope of present invention. The benefits, advantages, solutions to problems, and any element(s) that may cause any benefit, advantage, or solution to occur or become more pronounced are not to be construed as a critical, required, or essential features or elements of any or all the claims.

The present invention discloses an adaptor for adapting the pin-out of a first laser package to a desired pin-out arrangement on a printed circuit board. In prior art, semiconductor laser packages of one design can only be used with optoelectronic circuit boards of a corresponding design. This is because the pin-out of the first laser package may not correspond with the desired pin-out for use with the optoelectronic circuit board. The adaptor according to the present invention provides the flexibility to adapt the pin-out of a first laser package for use in conjunction with an optoelectronic circuit board that requires a different pin-out (hereinafter desired pin-out).

The adaptor, in accordance with various embodiments of the present invention, comprises a pin-in arrangement that mates with the pin-out of the first laser package. Further, the adaptor comprises an adaptor pin-out arrangement that is geometrically identical to the desired pin-out arrangement. The pin-in arrangement and the adaptor pin-out arrangement are electrically connected via a plurality of electrical paths. The adaptor pin-out arrangement may further be connected to the optoelectronic circuit board. This provides an inexpensive and convenient way to adapt the pin-out of the first laser package for use with any desired optoelectronic circuit boards.

In an embodiment, the present invention may be employed to adapt the pin-out of a coaxial laser package to a butterfly laser package.

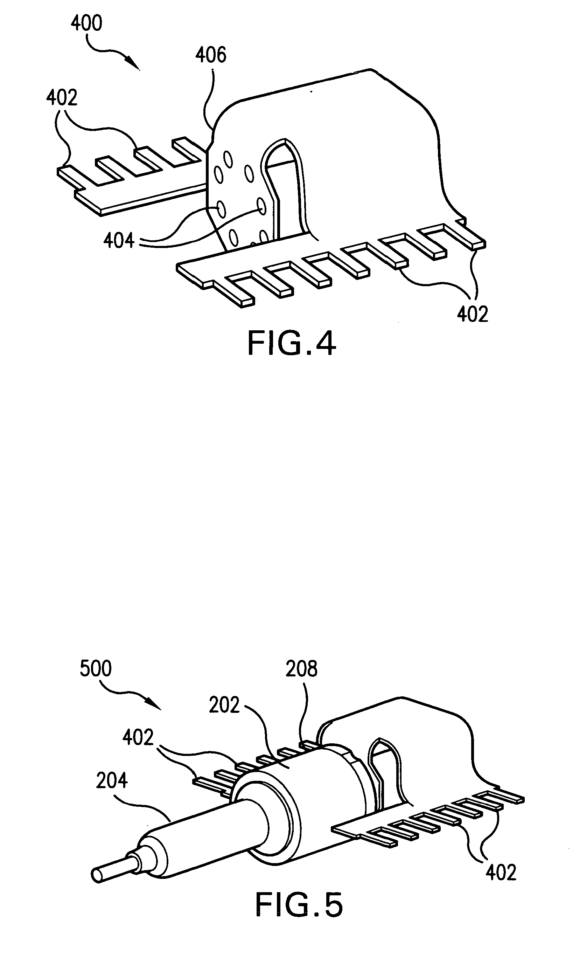

FIG. 4 shows an isometric view of a flex-circuit used in an adaptor in accordance with an embodiment of the present invention. The flex-circuit shown in the figure adapts coaxial pin-out 206 to butterfly pin-out 106. The figure shows a flex-circuit 400 comprising two rows of pins that are arranged in a design geometrically identical to a desired pin-out 402 (in the case a butterfly pin-out). Flex-circuit 400 also comprises annular holes 404 that are designed to electrically couple with a coaxial laser package pin-out. The two parallel rows of pins in desired pin-out 402 are on the same plane, which makes it convenient to integrate the package with the optoelectronic circuit board. Flex-circuit 400 further comprises a circular surface 406. Circular surface 406 has annular holes 404 arranged on it to mate with coaxial pin-out 206 (as shown in figure FIG. 2), thereby forming a pin-in arrangement. Annular holes 404 formed on the circular surface 406 of flex-circuit 400 constitute a pin-in arrangement in the adaptor, which mates with coaxial pin-out 206.

In an embodiment of the present invention, flex-circuit 400 is made of copper foils, polyimide and adhesive laminates. It will be apparent to the reader that various suitable materials known in the art may be used for construction of flex-circuit 400.

Desired pin-out 402 geometrically simulates butterfly pin-out 106 (as shown in FIG. 1) of butterfly laser package 100. In other words, the pattern and dimension of desired pin-out 402 of flex-circuit 400 are substantially identical to butterfly pin-out 106.

In an embodiment of the present invention, flex-circuit 400 can be bended to take a desired shape using appropriate forming tools. It will be apparent to one skilled in the art that various orientations or shapes of flex-circuit 400 can be attained using suitable forming tool known in the art.

Flex-circuit 400 further comprises electronic traces (not shown in figure) running inside flex-circuit 400 to connect the pins of coaxial pin-out 206 to the corresponding pins of desired pin-out 402 formed on flex-circuit 400. These features eliminate the need to bend coaxial pin-out 206 formed on coaxial laser package 200 to make it adaptable for butterfly application.

FIG. 5 shows an isometric view of coaxial laser package flex-circuit subassembly 500. Coaxial pin-out 206 of coaxial laser package 200 is passed through annular holes 404 formed on circular surface 406 of flex-circuit 400. This configuration enables the formation of continuous electrical connections between the pins of coaxial pin-out 206 and desired pin-out 402.

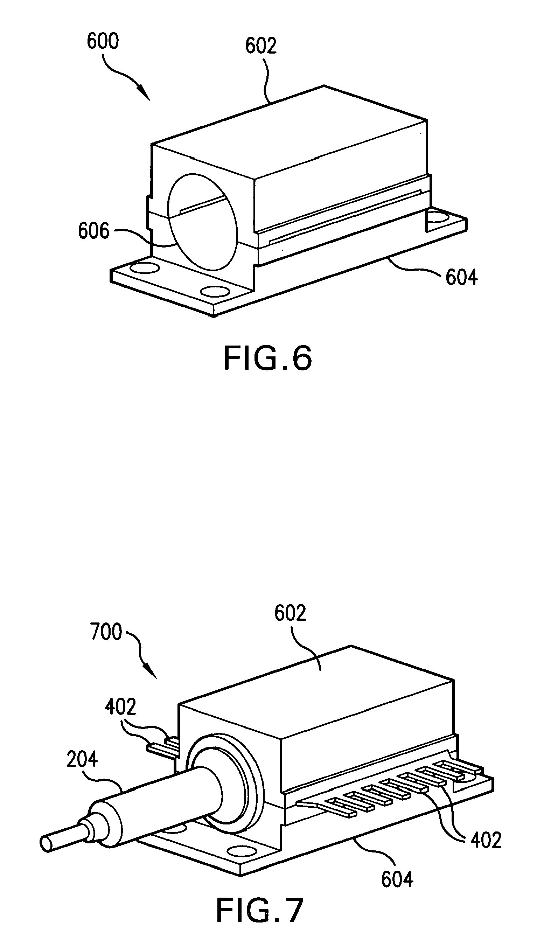

FIG. 6 shows an isometric view of a clamshell 600 for use in conjunction with flex-circuit 400, in accordance with an embodiment of the present invention. Clamshell 600 is a two-piece arrangement with a top portion 602 and a bottom portion 604.

In an embodiment of the present invention, clamshell 600 has a cylindrical bore 606, which is formed by joining semi-circular half formed within top portion 602 with another semi-circular half formed within bottom portion 604. In various embodiments, there may be other internal cavities (not shown in the Figure) formed within clamshell 600 to accommodate the first laser package and flex-circuit 400 suitably.

Clamshell 600 serves to hold flex-circuit 400 and coaxial laser package 200 together in a single flat format. Further, it serves as a heat sink to dissipate heat generated from laser diode and other internal heat sources. For example, clamshell 600 is thermally conductive to the hot side of Thermal Electronic Cooler (TEC) in a cooled first laser package, and serves to dissipate the heat produced by the laser diodes and TEC in the first laser package.

In an embodiment of the present invention, top portion 602 and bottom portion 604 are fastened together using screws. In another embodiment of the present invention, top portion 602 and bottom portion 604 are held together by epoxy bonding. It will be apparent to one skilled in the art that various fastening means can be used to join top portion 602 and bottom portion 604 of clamshell 600, depending on the application.

In another embodiment of the present invention clamshell 600 can be made by machining or by molding using materials with high thermal conductivity, such as aluminum, copper or other metals. It will be apparent to the one skilled in the art that various other known material can be used for the construction of clamshell 600 without deviating from the scope of the present invention.

In yet another embodiment of the present invention, an interface material can be interposed between TO-can 208 of coaxial laser package 200 and cylindrical bore 606 of clamshell 600 for thermal contact purposes. It will be apparent to the one skilled in the art that various known materials can be used as for such thermal contact including for non-limiting example thermal epoxy, and thermal pads.

In an embodiment of the present invention, the footprint of clamshell 600 is the same as the footprint of butterfly laser package 100. In another embodiment of the present invention, the footprint of clamshell 600 is selected depending upon the application that uses the adaptor.

FIG. 7 shows complete assembly of an adapted semiconductor laser package 700, which comprises coaxial laser package 200 with flex-circuit 400 and clamshell 600. Coaxial laser package 200, flex-circuit 400, and clamshell 600 are assembled together and sealed. Adapted laser package 700 is ready to be used in butterfly laser package applications without any modifications.

In an embodiment of the present invention, the electrical traces within flex-circuit 400 may provide one-to-one connections between the pins of coaxial pin-out 206 and desired pin-out 402. In another embodiment, certain pins of coaxial pin-out 206 may be connected to more than one pins of desired pin-out 402. Alternatively, certain pins in coaxial pin-out 206 may be not connected to pins of desired pin-out 402. It would be apparent to one skilled in the art that various connections between the pins of coaxial pin-out 206 and the pins of desired pin-out 402 may be used based on the application of the adaptor, without deviating from the spirit and scope of the present invention.

In an embodiment of the present invention, the screwing together of top portion 602 and bottom portion 604 serves to seal adapted laser package 700. In another embodiment, epoxy bonding is used to seal adapted laser package 700. It will be apparent - to one skilled in-the-art-that-various-other means of sealing the first laser-package can be employed without deviating from the scope of the invention.

It will be apparent to one skilled in the art that a large variety designs and materials that are known in the art may be used for flex-circuit 400 and clamshell 600 to function as adaptor providing a plurality of electrical paths to connect the pin-in arrangement with the adaptor pin-out arrangement.

The examples under the present invention, detailed in the illustrative examples contained here, are described using terms and constructs drawn largely from an adaptor to adapt a coaxial laser package for butterfly applications. But use of these examples should not be interpreted to limiting the invention to these semiconductor laser packages. The methods and principles disclosed by the present invention can be of use and provided to adapt any semiconductor laser package for any application.

While the preferred embodiments of the invention have been illustrated and described, it will be clear that the invention is not limited to these embodiments only. Numerous modifications, changes, variations, substitutions and equivalents will be apparent to those skilled in the art without departing from the spirit and scope of the invention as described in the claims.

## Claims

1. An adaptor suitable for use in an optoelectronic circuit board for adapting a package pin-out arrangement to a desired pin-out arrangement, the adaptor comprising:
a. a pin-in arrangement designed to electrically couple with the package pin-out arrangement;
b. an adaptor pin-out arrangement that is geometrically identical to the desired pin-out arrangement; and
c. a flex-circuit comprising a plurality of electrical paths to connect the pin-in arrangement to the adaptor pin-out arrangement.

2. The adaptor of claim 1, wherein the adaptor further comprises a clamshell holding the flex-circuit and the package pin-out arrangement together in a single flat format.

3. The adaptor of claim 2, wherein the clamshell is fabricated, at least in part, from a thermal conductor.

4. The adaptor of claim 3, wherein the thermal conductor is selected from a group consisting of metal and alloys.

5. The adaptor of claim 3, wherein the thermal conductor is selected from a group consisting of Al, Cu, cold rolled steel or other alloys.

6. The adaptor of claim 1, wherein the clamshell has a cylindrical bore.

7. The adaptor of claim 6, wherein the cylindrical bore accommodates the TO-can of the package.

8. The adaptor of claim 2, wherein the clamshell has internal cavities to accommodate the flex-circuit.

9. The adaptor of claim 2, wherein the clamshell is a two-piece arrangement.

10. The adaptor of claim 9, wherein the two-piece arrangement is held together by screws.

11. The adaptor of claim 9, wherein the two-piece arrangement is held together by epoxy bonding.

12. The adaptor of claim 7, wherein the cylindrical bore of the clamshell is in thermal contact with the TO-can of the package via an interface material.

13. The adaptor of claim 12, wherein the interface material is selected from a group consisting of thermal epoxy, thermal pad, or thermal grease.

14. The adaptor of claim 1, wherein the flex-circuit is made of, at least in part, copper foils, polyimide, and an adhesive laminate.

15. The adaptor of claim 1, wherein the adaptor pin-out arrangement geometrically corresponds to a butterfly laser package pin-out arrangement.

16. The adaptor of claim 1, wherein the package is a coaxial laser package.

17. The adaptor of claim 1, wherein the pin-in arrangement comprises a plurality of annular holes that are geometrically arranged to mate with the pin-out of the package.

18. The adaptor of claim 1, wherein there is one-to-one electronic coupling between the annular holes of the pin-in arrangement and the pin-out of the adaptor pin-out arrangement.

19. The adaptor of claim 1, wherein the package pin-out arrangement is an assembled and sealed device.

20. An adaptor suitable for use in an optoelectronic circuit board for adapting a package pin-out arrangement to a desired pin-out arrangement, the adaptor comprising:
a. a flex-circuit comprising:
i. a pin-in arrangement designed to electrically couple with the package pin-out arrangement;
ii. an adaptor pin-out arrangement that is geometrically identical to the desired pin-out arrangement; and
iii. one-to-one electrical connections between the pin-out of the package pin-out arrangement and the adaptor pin-out arrangement.
